(19) Europäisches Patentamt

European Patent Office

Office européen des brevets

(11) **EP 0 313 000 B1**

(12) **EUROPÄISCHE PATENTSCHRIFT**

(45) Veröffentlichungstag und Bekanntmachung des Hinweises auf die Patenterteilung:
06.05.1998 Patentblatt 1998/19

(51) Int Cl.⁶: **H01L 29/739**, H01L 21/331, H01L 29/08, H01L 21/24

(21) Anmeldenummer: 88117355.3

(22) Anmeldetag: 18.10.1988

(54) **Verfahren zum Herstellen eines Bipolartransistors mit isolierter Gateelektrode**

Method of making an insulated gate bipolar transistor

Méthode de fabrication d'un transistor bipolaire à grille isolée

(84) Benannte Vertragsstaaten:
CH DE FR GB IT LI SE

(30) Priorität: 21.10.1987 DE 3735642

(43) Veröffentlichungstag der Anmeldung:
26.04.1989 Patentblatt 1989/17

(73) Patentinhaber: SIEMENS AKTIENGESELLSCHAFT
80333 München (DE)

(72) Erfinder:
• **Fellinger, Christine**
D-8025 Unterhaching (DE)
• **Tihanyi, Jenö, Dr. Ing.**
D-8000 München 70 (DE)

(56) Entgegenhaltungen:
EP-A- 148 065          FR-A- 2 235 494
US-A- 2 802 759

• **PATENT ABSTRACTS OF JAPAN, Band 7, Nr. 214 (E-199)[1359], 21. September 1983; & JP-A-58 106 825 (MATSUSHITA DENKI SANGYO K.K.) 25.06.1983**

## Beschreibung

Die Erfindung bezieht sich auf ein Verfahren nach dem Oberbegriff des Anspruchs 1. Alternativ dazu bezieht sie sich auf ein Verfahren nach dem Oberbegriff des Anspruchs 3.

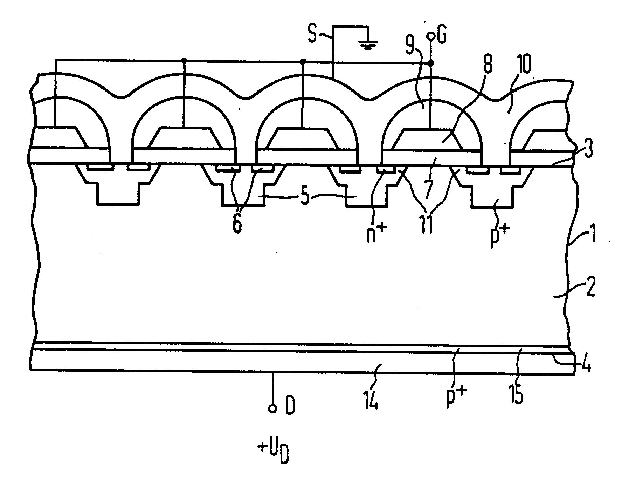

Ein solches Verfahren ist z.B. in der EP-0 148 065 A2 beschrieben worden. In Figur 18 dieses Dokuments ist ein Bipolartransistor mit isolierter Gateelektrode beschrieben, der katodenseitig wie ein Leistungs-MOSFET aufgebaut ist, jedoch anodenseitig eine Zone hat, die den entgegengesetzten Leitungstyp wie die Mittelzone aufweist. Am Stromtransport sind hier wie beim Thyristor, aber im Gegensatz zum Leistungs-MOSFET beide Arten von Ladungsträgern beteiligt. Das bringt einerseits den Vorteil eines niedrigen Durchlaßwiderstandes, andererseits aber den Nachteil einer Speicherladung, die das Abschalten verzögert.

Die Speicherladung wird nach D1 dadurch vermindert, daß anodenseitig Ionen implantiert werden, wodurch eine sehr dünne Anodenzone entsteht. Außerdem ist die Anodenseite mit einer Metallschicht zur Kontaktierung versehen. Durch die dünne Anodenzone wird die Zahl der Minoritätsladungsträger in der Mittelzone verringert, was zu einer Verringerung der Ausschaltzeit führt.

Außerdem beschreibt US-A-2 802 759 ein Verfahren zur Erzugung eines ebenen PN-Übergangs durch Metallbedampfung und Erhitzung über die entektische Temperatur.

Die der Erfindung zugrundeliegende Aufgabe besteht darin, unter Verwendung des bekannten Verfahrens einen preiswerten durch Feldeffekt steuerbaren Bipolartransistor mit geringer Speicherladung herzustellen.

Dieses Ziel wird gemäß dem Kennzeichnenden Teil des Anspruchs 1 dadurch erreicht, daß die Mittelzone nach der Fertigstellung der Katodenseite des Bipolartransistors auf eine Dicke herabgesetzt wird, die etwa 2-3 mal größer ist als die Breite der Raumladungszone für die vorgesehene Sperrspannungsklasse, daß dann der Dotierstoff implantiert wird, daß der Halbleiterkörper nach dem Implantieren auf eine Temperatur erwärmt wird, bei dem eine Legierung aus Silizium und dem Metall entsteht, und daß der Halbleiterkörper dann abgekühlt wird, bis eine rekristallisierte Anodenzone (15) vom zweiten Leitungstyp entsteht. Gemäß dem kennzeichnenden Teil des Anspruch 3 wird dieses Ziel dadurch erreicht, daß die Mittelzone nach der Fertigstellung er Katodenseite des Bipolartransistors auf eine Dicke herabgesetzt wird, die etwa 2-3 mal größer ist als die Breite der Raumladungszone für die vorgesehene Spannungsklasse, daß der Halbleiterkörper auf eine Temperatur erwärmt wird, bei der eine Aluminium-Silizium-Legierung entsteht, und daß der Halbleiterkörper dann abgekühlt wird, bis eine rekristallisierte Anodenzone (15) vom zweiten leitungstyp entsteht.

Die Erfindung wird anhand eines Ausführungsbeispiels in Verbindung mit der Figur näher erläutert. Diese zeigt einen Schnitt durch das beschriebene Ausführungsbeispiel.

Der Bipolartransistor hat einen Halbleiterkörper 1 mit einer n-dotierten Mittelzone 2. Die Dotierung liege z.B. bei 1 bis $2 \times 10^{14} cm^{-3}$. Der Halbleiterkörper hat eine katodenseitige Oberfläche 3 und eine anodenseitige Oberfläche 4. Die Mittelzone 2 reicht bis an die katodenseitige Oberfläche 3. Angrenzend an diese Oberfläche sind Gatezonen 5 eingebettet, die stark p-dotiert sind. In den Gatezonen 5 ist jeweils eine stark n-dotierte Sourcezone 6 eingebettet. Ihre Dotierung ist stärker als die der Gatezonen 5. Auf der Oberfläche 3 ist eine Isolierschicht 7 vorgesehen, auf der einander parallelgeschaltete Gateelektroden 8 sitzen. Die Gateelektroden überdecken einen an die Oberfläche 3 tretenden Teil der Gatezonen 5 an den Kanalzonen 11, d. h. an denjenigen Stellen, in denen sich der Kanal zwischen den Sourcezonen 6 und der Mittelzone 2 ausbilden soll. Die Gateelektroden 8 sind von einer weiteren Isolierschicht 9 bedeckt. In den Isolierschichten 7 und 9 sind Öffnungen vorgesehen, durch die die Sourcezonen 6 und die Gatezonen 5 von einer auf der Isolierschicht 9 liegenden Metallschicht 10 kontaktiert sind. Die Metallschicht besteht vorzugsweise aus Aluminium. Die Kontaktierung der Zonen 5 und 6 durch die Metallschicht 10 stellt einen starken Nebenschluß dar.

Zwischen der Mittelzone 2 und der anodenseitigen Oberfläche 4 liegt eine stark p-dotierte Schicht 15. Diese Schicht ist Silizium, das aus einem Gold-Silizium-Eutektikum 14 rekristallisiert ist. Sie enthält als Dotierstoff z. B. Bor. Das nach dem Abkühlen und Rekristallisieren verbleibende Gold-Silizium-Eutektikum 14 bildet die Anodenelektrode. Die Schicht 15 kann durch entsprechende Prozeßführung bei der Herstellung sehr dünn gemacht werden, z. B. 1/10 μm.

Durch die dünne $p^+$-Zone 15 läßt sich die hauptsächlich in der Mittelzone 2 gespeicherte Trägerspeicherladung drastisch verringern. Dabei wurde die Erkenntnis angewandt, daß die Speicherladung Q in erster Näherung durch folgende Formel gegeben ist:

$$Q = \frac{N_{AP}}{N_{Dn}} \times W_P \times I \times A \times K$$

Hierin ist $N_{AP}$ und $N_{Dn}$ die Nettoakzeptorkonzentration in der Schicht 15 bzw. die Nettodonatorkonzentration in der Mittelzone 2, $W_P$ die Dicke der Schicht 15, I der Strom, $D_n$ die Diffusionskonstante in der Zone 2, q die Elementarladung und A die Fläche des Halbleiterkörpers. Die Konstante K bestimmt sich, ebenfalls in erster Näherung, zu

$$K = \frac{2}{3} \times \frac{1}{D_n q} \times Wn \quad (Wn = Dicke\ der\ Zone\ 2).$$

Es ist ersichtlich, daß die Größe $W_p$ linear in die Speicherladung eingeht. Daneben wird die Speicherladung noch von dem Verhältnis der Nettodotierungskonzentrationen bestimmt. Dieses Verhältnis wird, wie bekannt, so eingestellt, daß sich befriedigende Durchlaßeigenschaften für den Bipolartransistor ergeben.

Ein bevorzugtes Verfahren zur Herstellung des Bipolartransistors ist:

In eine n-dotierte Scheibe von z. B. 600 µm Dicke werden auf bekannte Weise die Gatezonen 5 und die Sourcezonen 6 eingebracht. Die Herstellung der Isolierschichten, Gateelektroden und der Metallschicht 10 geschieht ebenfalls auf die von der Herstellung von Leistungs-MOSFET her bekannte Weise. Nachdem der Transistor katodenseitig fertiggestellt ist, kann die Dicke des Halbleiterkörpers durch Schleifen oder Sandstrahlen oder ähnliches von der Anodenseite her auf eine Dicke gebracht werden, die etwa zwei bis dreimal größer ist als die Breite der Raumladungszone für die vorgesehene Sperrspannungsklasse ist, z. B. 200 bis 300 pm. Dann wird die durch die mechanische Bearbeitung gestörte Schicht durch Ätzen abgetragen. Hierbei kann ein Teil der Schicht erhalten bleiben, da die durch die Bearbeitung erzeugten Störstellen wie Rekombinationszentren wirken. Anschließend wird in die anodenseitige Oberfläche ein Dotierstoff, z. B. Bor implantiert. Dies kann mit einer Dosis von z. B. $5 \times 10^{14} cm^{-2}$ und einer Energie von 80 keV geschehen. Nun wird z. B. reines Gold in einer Dicke von 0,1 µm auf der anodenseitigen Oberfläche abgeschieden. Beim nachfolgenden Erwärmen der Scheibe z. B. auf 400 °C für eine Dauer von 30 Minuten bildet sich ein Gold-Silizium-Eutektikum, das Bor-Ionen enthält. Wird das Halbleiterbauelement nach Bildung einer genügend dicken Eutektikumsschicht z. B. innerhalb von 10 Minuten wieder abgekühlt, so rekristallisiert angrenzend an die Zone 2 die Schicht 15 aus, die aus Silizium mit eingelagerten Bor-Ionen besteht. Der Rest des Gold-Silizium-Eutektikums 14 kann als Kontaktelektrode verwendet werden. Diese kann mit einem Trägerkörper z. B. verklebt oder nach Aufbringen von weiteren Metallschichten, z.B. TiNiAg, verlötet werden.

Das Erzeugen von dotierten Zonen durch Legieren über ein Gold-Silizium Eutektikum ist bekannt. Statt des reinen Goldes kann z.B. auch eine Germanium-Goldlegierung verwendet werden. Es ist auch möglich, anstelle des Goldes und der implantierten Bor-Ionen eine Aluminiumschicht aufzudampfen, die dann in bekannter Weise einlegiert wird. Vorzugsweise sollte das Legieren jedoch mit einem Metall oder einer Legierung erfolgen, deren eutektische Temperatur niedriger liegt als diejenige Temperatur, die die auf der Katodenseite vorgesehenen Strukturen stören könnte. Empfindlich ist hier insbesondere die Kontaktschicht 10, die üblicherweise aus Aluminium besteht. Die eutektische Temperatur von Gold/Silizium liegt unterhalb dieser Temperatur.

Mit einem solchen Bipolartransistor wurde an induktiver Last bei einer Spannung von 600 V und 15 A Laststrom ein Abschalten in einer Zeit von kleiner als 100 ns erreicht. Die Abschaltzeit wurde wie üblich als die Zeit gemessen, die zwischen dem Abfall des Stroms auf 90 % bis 10 % verstreicht.

Ein weiterer Vorteil der Erfindung ist darin zu sehen, daß als Halbleiterkörper keine teure Epitaxie-Scheibe verwendet werden muß, sondern billiges Halbleiter-Grundmaterial. Die angegebene Dotierung von 1 bis $2 \times 10^{14} cm^{-3}$ läßt sich durch das bekannte und übliche Zonenschmelzen einfach einstellen, ohne daß es weiterer Dotierungsschritte am Grundkörper bedarf.

Die Erfindung wurde anhand eines Ausführungsbeispiels beschrieben, das eine Vielzahl elektrisch parallelgeschalteter Gatezonen, Sourcezonen und Gateelektroden hat. Es ist aber auch möglich, die Erfindung bei einem Transistor anzuwenden, der jeweils nur eine einzige jeweils fingerförmige Gatezone, Sourcezone und Gateelektrode hat.

Es ist auch nicht unbedingt notwendig, ein Metall-Silizium-Eutektikum zu bilden oder Metalle zu benutzen, die mit Silizium ein Eutektikum bilden. Wesentlich ist aber, daß die rekristallisierte Schicht Dotierstoffatome enthält.

## Patentansprüche

1. Verfahren zum Herstellen eines Bipolartransistors mit mindestens einer isolierten Gateelektrode, mit einem aus Silizium bestehenden Halbleiterkörper mit den Merkmalen:

a)der Halbleiterkörper hat eine Mittelzone (2) von gegebener Dotierungshöhe und vom ersten Leitungstyp;
b)die Mittelzone grenzt an die katodenseitige Oberfläche (3) des Halbleiterkörpers an;
c)angrenzend an die katodenseitige Oberfläche ist mindestens eine Gatezone (5) vorgesehen, die an die Mittelzone angrenzt;
d)die Gatezone ist vom zweiten Leitungstyp und hat höhere Dotierung als die Mittelzone;
e)in der Gatezone (5) ist eine Sourcezone (6) vom erstem Leitungstyp vorgesehen, die an die katodenseitige Oberfläche angrenzt;
f)die Gateelektrode sitzt auf einer auf der katodenseitigen Oberfläche aufgebrachten Isolierschicht (7) und überdeckt die Gatezone;
g)zwischen anodenseitiger Oberfläche (4) des Halbleiterkörpers und der Mittelzone ist eine Anodenzone (15) vom zweiten Leitungstyp vorgesehen, die sehr dünn, beispielsweise 0,1 µm dick, ist und eine höhere Dotierungskonzentration als die Mittelzone hat;
h)zwischen Gatezone und Sourcezone ist ein Nebenschluß vorgesehen,
i)bei dem in die Mittelzone anodenseitig ein Dotierstoff vom zweiten Leitungstyp implantiert wird und anodenseitig ein Metall aufgebracht wird,

**dadurch gekennzeichnet,**

daß die Mittelzone (2) nach der Fertigstellung der Katodenseite des Bipolartransistors auf eine Dicke herabgesetzt wird, die etwa 2-3 mal größer ist als die Breite der Raumladungszone für die vorgesehene Sperrspannungsklasse, daß dann der Dotierstoff implantiert wird, daß der Halbleiterkörper nach dem Implantieren auf eine Temperatur erwärmt wird, bei dem eine Legierung aus Silizium und dem Metall entsteht, und daß der Halbleiterkörper dann abgekühlt wird, bis eine rekristallisierte Anodenzone (15) vom zweiten Leitungstyp entsteht.

2. Verfahren nach Anspruch 1,
**dadurch gekennzeichnet,**
daß als Metall Gold aufgebracht wird, daß der Halbleiterkörper auf eine Temperatur erwärmt wird, bei der ein Gold-Silizium-Eutektikum entsteht und daß der Halbleiterkörper abgekühlt wird, bis die rekristallisierte Anodenzone (15) entsteht.

3. Verfahren zum Herstellen eines Bipolartransistors mit mindestens einer isolierten Gateelektrode, mit einem aus Silizium bestehenden Halbleiterkörper mit den Merkmalen:

a)der Halbleiterkörper hat eine Mittelzone (2) von gegebener Dotierungshöhe und vom ersten Leitungstyp;
b)die Mittelzone grenzt an die katodenseitige Oberfläche (3) des Halbleiterkörpers an;
c)angrenzend an die katodenseitige Oberfläche ist mindestens eine Gatezone (5) vorgesehen, die an die Mittelzone angrenzt;
d)die Gatezone ist vom zweiten Leitungstyp und hat höhere Dotierung als die Mittelzone;
e)in der Gatezone (5) ist eine Sourcezone (6) vom ersten Leitungstyp vorgesehen, die an die katodenseitige Oberfläche angrenzt;
f)die Gateelektrode sitzt auf einer auf der katodenseitigen Oberfläche aufgebrachten Isolierschicht (7) und überdeckt die Gatezone;
g)zwischen anodenseitiger Oberfläche (4) des Halbleiterkörpers und der Mittelzone ist eine Anodenzone (15) vom zweiten Leitungstyp vorgesehen, die sehr dünn, beispielsweise 0,1 µm dick, ist und eine höhere Dotierungskonzentration als die Mittelzone hat;
h)zwischen Gatezone und Sourcezone ist ein Nebenschluß vorgesehen,
i)bei dem anodenseitig Aluminium aufgebracht wird,

**dadurch gekennzeichnet,**

daß die Mittelzone nach der Fertigstellung der Katodenseite des Bipolartransistors auf eine Dicke herabgesetzt wird, die etwa 2-3 mal größer ist als die Breite der Raumladungszone für die vorgesehene Spannungsklasse, daß der Halbleiterkörper auf eine Temperatur erwärmt wird, bei der eine Aluminium-Silizium-Legierung entsteht, und daß der Halbleiterkörper dann abgekühlt wird, bis eine rekristallisierte Anodenzone (15) vom zweiten Leitungstyp entsteht.

**Claims**

1. Method for the production of a bipolar transistor having at least one insulated gate electrode, having a semiconductor body composed of silicon and having the features:

a) the semiconductor body has a central zone (2) which has a given doping level and is of the first conduction type;
b) the central zone adjoins the cathode-side surface (3) of the semiconductor body;
c) adjoining the cathode-side surface, provision is made of at least one gate zone (5), which adjoins the central zone;
d) the gate zone is of the second conduction type and has a higher doping than the central zone;
e) a source zone (6) of the first conduction type is provided in the gate zone (5) and adjoins the cathode-side surface;
f) the gate electrode is seated on an insulating layer (7) applied to the cathode-side surface and covers the gate zone;
g) an anode zone (15) of the second conduction type is provided between the anode-side surface (4) of the semiconductor body and the central zone, which anode zone is very thin, for example 0.1 µm thick, and has a higher doping concentration than the central zone;
h) a shunt is provided between gate zone and source zone,
i) in which a dopant of the second conduction type is implanted into the central zone on the anode side, and a metal is applied on the anode side,

characterized
in that after the completion of the cathode side of the bipolar transistor, the central zone (2) is reduced to a thickness which is about 2-3 times greater than the width of the space charge zone for the intended reverse voltage class, in that the dopant is then implanted, in that after implantation the semiconductor body is heated to a temperature at which an alloy of silicon and the metal is produced, and in that the semiconductor body is then cooled until a recrystallized anode zone (15) of the second conduction type is produced.

2. Method according to Claim 1, characterized in that gold is applied as the metal, in that the semiconductor body is heated to a temperature at which a gold-silicon eutectic is produced, and in that the semiconductor body is cooled until the recrystallized anode zone (15) is produced.

3. Method for the production of a bipolar transistor having at least one insulated gate electrode, having a semiconductor body composed of silicon and having the features:

a) the semiconductor body has a central zone (2) which has a given doping level and is of the first conduction type;
b) the central zone adjoins the cathode-side surface (3) of the semiconductor body;
c) adjoining the cathode-side surface, provision is made of at least one gate zone (5), which adjoins the central zone;
d) the gate zone is of the second conduction type and has a higher doping than the central zone;
e) a source zone (6) of the first conduction type is provided in the gate zone (5) and adjoins the cathode-side surface;
f) the gate electrode is seated on an insulating layer (7) applied to the cathode-side surface and covers the gate zone;
g) an anode zone (15) of the second conduction type is provided between the anode-side surface (4) of the semiconductor body and the central zone, which anode zone is very thin, for example 0.1 μm thick, and has a higher doping concentration than the central zone;
h) a shunt is provided between gate zone and source zone,
i) in which aluminium is applied on the anode side,

characterized
in that after the completion of the cathode side of the bipolar transistor, the central zone is reduced to a thickness which is about 2-3 times greater than the width of the space charge zone for the intended voltage class, in that the semiconductor body is heated to a temperature at which an aluminium-silicon alloy is produced, and in that the semiconductor body is then cooled until a recrystallized anode zone (15) of the second conduction type is produced.

## Revendications

1. Méthode de fabrication d'un transistor bipolaire pourvu d'au moins une électrode de grille et comprenant un corps semi-conducteur en silicium possédant les caractéristiques suivantes :

a) le corps semi-conducteur possède une zone intermédiaire (2) du premier type de conductivité ayant un niveau de dopage défini;
b) la zone intermédiaire est contiguë à la surface (3) du corps semi-conducteur située du côté de la cathode;
c) on prévoit, contiguë à la surface située du côté de la cathode, au moins une zone de grille (5) qui est contiguë à la zone intermédiaire;
d) la zone de grille est du second type de conductivité et a un dopage plus élevé que la zone intermédiaire;
e) on prévoit, dans la zone de grille (5), une zone de source (6) du premier type de conductivité qui est contiguë à la surface située du côté de la cathode;
f) l'électrode de grille repose sur une couche isolante (7) appliquée sur la surface située du côté de la cathode et couvre la zone de grille;
g) on prévoit, entre la surface (4) du corps semi-conducteur située du côté de l'anode et la zone intermédiaire, une zone anodique (15) du second type de conductivité qui est très mince - elle mesure par exemple 0,1 μm d'épaisseur - et a une concentration de dopage plus élevée que la zone intermédiaire;
h) une dérivation est prévue entre la zone de grille et la zone de source;
i) dans laquelle un agent de dopage du second type de conductivité est implanté dans la zone intermédiaire sur le côté de l'anode et un métal est appliqué sur le côté de l'anode,

caractérisée en ce que, une fois que le côté cathode du transistor bipolaire est terminé, l'épaisseur de la zone intermédiaire (2) est diminuée jusqu'à l'obtention d'une épaisseur environ deux à trois fois supérieure à la largeur de la zone de charge spatiale pour la catégorie de tension de blocage prévue, en ce que l'agent de dopage est alors implanté, en ce que le corps semi-conducteur est chauffé, après l'implantation, à une température à laquelle un alliage du silicium et du métal se forme, et en ce que le corps semi-conducteur est ensuite refroidi jusqu'à l'obtention d'une zone anodique recristallisée (15) du second type de conductivité.

2. Méthode selon la revendication 1, caractérisée en ce que le métal appliqué est de l'or, en ce que le corps semi-conducteur est chauffé à une température à laquelle un mélange eutectique or-silicium se forme et en ce que le corps semi-conducteur est refroidi jusqu'à l'obtention de la zone anodique recristallisée (15).

3. Méthode de fabrication d'un transistor bipolaire pourvu d'au moins une électrode de grille et comprenant un corps semi-conducteur en silicium possédant les caractéristiques suivantes :

a) le corps semi-conducteur possède une zone intermédiaire (2) du premier type de conductivité ayant un niveau de dopage défini;
b) la zone intermédiaire est contiguë à la surface (3) du corps semi-conducteur située du côté de la cathode;
c) on prévoit, contiguë à la surface située du côté de la cathode, au moins une zone de grille (5) qui est contiguë à la zone intermédiaire;
d) la zone de grille est du second type de conductivité et a un dopage plus élevé que la zone intermédiaire;
e) on prévoit, dans la zone de grille (5), une zone de source (6) du premier type de conductivité qui est contiguë à la surface située du côté de la cathode;
f) l'électrode de grille repose sur une couche isolante (7) appliquée sur la surface située du côté de la cathode et couvre la zone de grille;
g) on prévoit, entre la surface (4) du corps semi-conducteur située du côté de l'anode et la zone intermédiaire, une zone anodique (15) du second type de conductivité qui est très mince - elle mesure par exemple 0,1 µm d'épaisseur - et a une concentration de dopage plus élevée que la zone intermédiaire;
h) une dérivation est prévue entre la zone de grille et la zone de source;
i) dans laquelle de l'aluminium est appliqué sur le côté de l'anode,

caractérisée en ce que, une fois que le côté cathode du transistor bipolaire est terminé, l'épaisseur de la zone intermédiaire est diminuée jusqu'à l'obtention d'une épaisseur environ deux à trois supérieure à la largeur de la zone de charge spatiale pour la catégorie de tension prévue, en ce que le corps semi-conducteur est chauffé à une température à laquelle un alliage aluminium-silicium se forme, et en ce que le corps semi-conducteur est ensuite refroidi jusqu'à l'obtention d'une zone anodique recristallisée (15) du second type de conductivité.